# EUROPEAN PATENT SPECIFICATION

(11) **EP 2 200 936 B1**
(45) Date of publication and mention of the grant of the patent: **29.06.2011**
(21) Application number: 08749792.1
(22) Date of filing: 28.04.2008
(51) Int. Cl.: C01B 33/14, H01L 31/18, C01B 33/146, C01B 33/16, H01L 21/225

(54) **SILICON DIOXIDE DISPERSION AND PROCESS FOR COATING SUBSTRATES**
SILICIUMDIOXIDDISPERSION UND VERFAHREN ZUM BESCHICHTEN VON SUBSTRATEN
DISPERSION DE DIOXYDE DE SILICIUM ET PROCÉDÉ DE REVÊTEMENT DE SUBSTRATS

(30) Priority: 16.05.2007 DE 102007023103
(43) Date of publication of application: 30.06.2010
(73) Proprietor: Evonik Degussa GmbH, 45128 Essen (DE)
(72) Inventor: DENG, Yi, 04157 Leipzig (DE); OSWALD, Monika, 63450 Hanau (DE); DELLER, Klaus, 63512 Hainburg (DE)
(86) International application number: PCT/EP2008/055168
(87) International publication number: WO 2008/138737

(56) References cited:
- EP-A1- 0 982 268
- WO-A1-98/37014
- US-A- 3 514 348
- US-A- 5 270 248
- ANASTASESCU M ET AL: "Loss of phosphorous in silica-phosphate sol-gel films" JOURNAL OF SOL-GEL SCIENCE AND TECHNOLOGY, KLUWER ACADEMIC PUBLISHERS, BO, vol. 40, no. 2-3, 27 June 2006 (2006-06-27), pages 325-333, XP019436276 ISSN: 1573-4846

## Description

The invention relates to a process for preparing a silicon dioxide dispersion, and to the silicon dioxide dispersion itself. The invention further relates to a process for coating substrates, especially silicon wafers.

In the production of solar cells, silicon wafers are generally doped with phosphorus in order to arrive at an n-semiconductor. For this purpose, a phosphorus-containing layer is first applied to the wafer and the layer is then treated at high temperature, as a result of which phosphorus can diffuse into the wafer.

To apply phosphorus-containing layers to a wafer, numerous methods are known in the prior art.
1. The article "Loss of phosphorus in silica-phosphate sol-gel films" (M. Anastasescu et al., J. Sol-Gel Sci. Techn., 2006, 40, 325-333) discloses a silica dispersion containing phosphoric acid as coating material.
2. The US application number 3514348 discloses a method of depositing a phosphorous doped silicon dioxide layer onto a semiconductor material.

For example, the APCVD process (atmospheric pressure chemical vapour deposition) (S. Sivoththaman, W. Laureys, P. De Schepper, J. Nijs and R. Mertens, "Selective Emitters in Si by Single Step Rapid Thermal Diffusion for Photovoltaic Devices", IEEE Electron Device Lett. 6 (21) 274-276, 2000), in which a mixture of PH₃ and SiH₄ is used. The deposition is effected at approx. 400°C and under atmospheric pressure.

In addition, a flow process can be used, in which POCl₃ and SiP₂O₇ are converted together with oxygen in a quartz glass reactor (C. Voyer, D. Biro, G. Emanuel, R. Preu, J. Koriath, H. Wanka, "Evaluation of Dopant Sources and Deposition Methods Suitable for in-line Diffusion in the PV Industry", in Proc. 19th EC Photovoltaic Solar Energy Conf., 2004).

In addition, a film-casting process can be used, in which a phosphorus-containing paste is applied to a wafer (L. Frisson, M. Honore, R. Mertens, R. Govaerts and R.V. Overstraten, Proc. 14th IEEE PVSC, San Diego, California, USA, 1980).

In addition, there are spraying processes in which a silicon- and phosphorus-containing sol is applied and thermally treated (US 5270248, US 5527389).

In the spin-coating process, a silicon- and phosphorus-containing sol is applied to a wafer by means of spin-coating (N.N. Toan, Thesis, University of Twente, "Spin-On-Glass Materials and Applications in Advanced IC Technologies", 1999).

The disadvantages of the known processes include complicated safety equipment, complicated measures for preventing damage to the coated wafer, or they are suitable only for the coating of wafers with a small surface area.

It was therefore an object of the present invention to provide a process for coating substrates, especially silicon wafers, which does not have the disadvantages of the prior art.

It was a further object of the invention to provide constituents of the coating, specifically silicon dioxide and phosphorus, in a form which technically simplifies the application of the coating and is economically viable.

The invention provides a process for preparing a silicon dioxide dispersion comprising phosphoric acid, in which phosphoric acid is added with stirring to a start dispersion I which comprises water and silicon dioxide particles to form start dispersion II, and then at least one silicon compound is added to start dispersion II and is hydrolysed in start dispersion II to form the silicon dioxide dispersion comprising phosphoric acid, where
- start dispersion I contains
   - 80 to 95% by weight of water
   - 5 to 20% by weight of silicon dioxide
   - and the sum of water and silicon dioxide is at least 98% by weight, based on start dispersion I,
- start dispersion II contains
   - 60 to 90% by weight of water
   - 5 to 20% by weight of silicon dioxide
   - 5 to 25% by weight of phosphoric acid, selected from ortho-phosphoric acid, diphosphoric acid and/or polyphosphoric acid, and
   - the sum of water, silicon dioxide and phosphoric acid is at least 98% by weight, based on the start dispersion,
- the silicon dioxide particles of start dispersion I and of start dispersion II have
   - a BET surface area of 80 to 350 m²/g,
   - and a mean aggregate diameter of less than 200 nm,
- the silicon compound which is hydrolysed in start dispersion II
   - is selected from at least one compound of the general formula (R₁O)ₓSi(OR₂)₄₋ₓ where R₁ and R₂ = Me, Et, n-propyl, isopropyl, n-butyl, x = 0-4 and R₁ ≠ R₂, and
   - is added in an amount such that the ratio of silicon dioxide from hydrolysis to silicon dioxide (calculated) from start dispersion II is 0.2 to 1.2.

In the invention, start dispersion I is defined as a dispersion which comprises silicon dioxide and water, to which no phosphoric acid has been added as yet.

In the invention, start dispersion II is defined as a dispersion which comprises silicon dioxide, water and phosphoric acid, to which no hydrolysable silicon compound has been added as yet.

A silicon dioxide dispersion comprising phosphoric acid is defined as a dispersion which comprises the product(s) which result from the hydrolysis of the silicon compound and a subsequent condensation in start dispersion II.

The silicon dioxide used, which is present in start dispersion I and II, may in principle be any silicon dioxide which has a BET surface area of 80 to 350 m²/g and a mean aggregate diameter of less than 200 nm. For example, precipitated silicon dioxide or pyrogenic silicon dioxide can be used. Preference is given to using pyrogenic silicon dioxide.

Pyrogenic is understood to mean silicon dioxide particles obtained by flame hydrolysis and/or flame oxidation. In this method, a silicon compound is converted in the gas phase in a flame, obtained by the reaction of a combustion gas, preferably hydrogen, and oxygen. This forms initially highly disperse, nonporous primary particles. Primary particles are ultra small particles which obviously cannot be decomposed any further. Several primary particles may combine to form aggregates at their contact points. These aggregates can be dissolved either only poorly or not at all by dispersion apparatus. Several aggregates may combine loosely to form agglomerates, and this process can be reversed again by suitable dispersion. The BET surface area of the primary particles in pyrogenic processes is generally between 5 and 600 m²/g. In the process according to the invention, silicon dioxide particles which have a BET surface area of 80 to 350 m²/g are used. The BET surface area is preferably 150 to 250 m²/g. When they are used for coating substrates, some of the best results with regard to surface quality are achieved.

An essential feature of the process according to the invention is that the mean aggregate diameter of the silicon dioxide particles in start dispersion I and II is less than 200 nm. Larger aggregate diameters lead to an inhomogeneous coating. The mean aggregate diameter is preferably less than 100 nm. Particular preference is given to a range between 70 and 100 nm.

Start dispersions I can be obtained either by dispersing silicon dioxide by means of suitable dispersion units, such as planetary kneaders, rotor-stator machines or high-energy mills. After the dispersion step, phosphoric acid is added to them to form start dispersion II. This does not change the mean aggregate diameter. The pH of the start dispersion I may be within a range of 2 to 11.5. Preference may be given to using a start dispersion whose pH is 5 to 6.

The content of silicon dioxide in start dispersion I is, in the process according to the invention, 5 to 20% by weight. Proportions of less than 5% by weight are technically not viable, since several coating steps are needed to achieve a homogeneous layer. Start dispersions I which have a proportion of silicon dioxide of more than 20% by weight are readily handleable as such, but do not lead to a homogeneous coating of substrates. The proportion of silicon dioxide in the predispersion is preferably 10 to 15% by weight.

A further significant feature of the process according to the invention is that a hydrolysable silicon compound is added in such an amount that the ratio of silicon dioxide from hydrolysis (calculated) to silicon dioxide from start dispersion II is 0.2 to 1.2. "Calculated" is understood to mean that the exact structure of the hydrolysis and condensation product(s) in the dispersion is not known and the proportion of these products according to the formula (RᵢO)ₓSi(OR₂)₄₋ₓ + H₂O → SiO₂ + x RᵢOH + (4-x) R₂OH is therefore reported as silicon dioxide.

When there are no hydrolysis and condensation products or they are present in the dispersion at a ratio of less than 0.2, only layers with unacceptable surface quality can be obtained. At a ratio of more than 1.2, especially in the case of phosphorus doping of silicon wafers, no further advantage can be achieved. The ratio of silicon dioxide from hydrolysis (calculated)/silicon dioxide from start dispersion II is preferably 0.4 to 0.8.

Owing to the good availability, the silicon compound used may preferably be tetramethoxysilane and/or tetraethoxysilane.

The best coating results are obtained when the silicon dioxide dispersion comprising phosphoric acid is diluted with at least one volatile organic solvent soluble in the liquid phase of the dispersion. "Soluble" is understood to mean that, after addition of the solvent, no immiscible liquid phase is formed. "Volatile" is understood to mean that the organic solvents can be removed again at temperatures up to 300°C.

Preference may be given to using alcohols selected from methanol, ethanol, n-propanol, isopropanol, n-butanol and/or 1,2-ethanediol. Particular preference is given to ethanol.

The molar ratio (mol/mol) of organic solvent/water is preferably 0.2 to 4. Particular preference is given to a range of 0.5 to 1.

The invention further provides a silicon dioxide dispersion comprising phosphoric acid, obtainable by the process according to the invention.

This dispersion preferably has the following features:
- 3 to 7.5% by weight of pyrogenic silicon dioxide particles having a BET surface area of 150 to 250 m²/g, a mean aggregate diameter of the silicon dioxide particles of less than 100 nm,
- 1.5 to 5% by weight of hydrolysis and condensation products of tetraethoxysilane, which have formed in the dispersion in the presence of the pyrogenic silicon dioxide particles,
- 5 to 9% by weight of phosphoric acid, calculated as H3PO4,
- 25 to 30% by weight of water,
- 50 to 65% by weight of ethanol,
- where the proportion of these substances is at least 98% by weight, based on the total amount of the dispersion.

The invention further provides a process for coating a silicon wafer in which the inventive phosphorus-containing silicon dioxide dispersion is applied to a substrate, then the coated substrate is dried and sintered.

The dispersion can be applied, for example, by means of spin-coating, dip-coating, painting, spraying or knife-coating. The layer applied can be dried preferably at room temperature (10 to 30°C).

The term "silicon wafer" includes monocrystalline silicon wafers, block-cast, multicrystalline silicon wafers, amorphous silicon wafers, or wafers composed of silicon ribbon or silicon tube, such as EFG wafers (EFG = edge-defined film-fed growth).

The sintering step of the process according to the invention can be performed by introducing the coated and dried silicon wafer, which is at room temperature, into an environment which has a temperature of 850 to 930°C, for example a conventional oven, keeping the silicon wafer at this temperature for 5 to 15 minutes and then transferring it into an environment at room temperature and allowing it to cool there. Room temperature is understood to mean temperatures of 10 to 30°C.

The very rapid heating of the silicon wafer promotes especially the formation of layers with a low layer resistance.

The invention further provides for the use of the silicon wafers coated by means of the process according to the invention for producing solar cells.

### Examples

### Start dispersions I

Start dispersion I/A: 12 per cent by weight dispersion of pyrogenic silicon dioxide having a BET surface area of 200 m²/g, a mean particle diameter of less than 100 mm, a pH of 5.5.

Start dispersion I/B: 20 per cent by weight dispersion of pyrogenic silicon dioxide having a BET surface area of 200 m²/g, a mean particle diameter of less than 100 nm, a pH of 5.3.

### Start dispersions II

Example 1A: 54 g of ortho-phosphoric acid (85% by weight in water) are added with stirring to 300 g of start dispersion I/A.

Examples 2A-10A are performed analogously. In Example 9A, start dispersion I/B is used. Feedstocks and composition of the dispersions are reproduced in Table 1.

### Silicon dioxide dispersions comprising phosphoric acid by the process according to the invention

Example 2B: 100 g of TEOS (tetraethoxysilane) are added to start dispersion II from Example 2A and the mixture is homogenized by stirring on a magnetic stirrer for 30 minutes.

Examples 2B-10B are carried out analogously. Dispersion 1B corresponds to dispersion 1A (not an inventive dispersion; no addition of TEOS). Feedstocks and composition of the dispersions are reproduced in Table 2.

### Dilute silicon dioxide dispersions comprising phosphoric acid by the process according to the invention

Example 1C: 444 ml of ethanol are added to the dispersion from Example 1B and the mixture is homogenized for 30 minutes.

Examples 2C, 3C and 5C-10C are carried out analogously. Feedstocks and composition of the dilute dispersions are reproduced in Table 3.

### Coating of glass substrates

The dispersions from Examples 1A, 4B, 1C-3C and 5C-10C were used to coat glass substrates. The dispersions are applied by means of dip-coating with variation of the drawing rate (2 to 20 cm/min), dried at room temperature and then sintered.

The dispersions from Examples 1A and 1C serve as comparative examples.

The surface quality of the coated sintered substrates was analysed by light microscopy. The phosphorus content in the layers before and after the sintering process was analysed by EDX. The layer thickness was determined by means of scanning electron microscopy (SEM).

The layer resulting from dispersion 1A with a drawing rate of 4 cm/min has high transparency but is very inhomogeneous. An increase in the drawing rate allows the homogeneity to be improved, but the quality of the coating is still not acceptable. The addition of ethanol (dispersion 1C) leads only to a slightly better surface quality.

The dispersions 2B to 10B modified with TEOS have, with the same drawing rate, a somewhat poorer transparency compared to the dispersions not modified with TEOS, but have excellent homogeneity overall.

The best results are obtained when the dispersion admixed with TEOS is then diluted with ethanol.

The layers have very good homogeneity and transparency. SEM analyses demonstrate that no microcracks are present. The layer thickness of the layer resulting from Example 6C is approx. 0.46 µm. Variation of drawing rate, concentration of TEOS and ethanol allows even thinner layers to be produced.

### Coating of EFG wafers

The dispersions from Examples 2C, 3C and 6C were applied to an EFG wafer by means of dip-coating (drawing rates 2 and 10 cm/min), dried at room temperature and then sintered.

Two sintering processes were used. The first sintering process comprises the heating of the EFG wafer, proceeding from room temperature to 900°C at a heating rate of 30 K/min, holding the temperature for 10 minutes, then allowing to cool to room temperature.

The second sintering process comprises the introduction of the EFG wafer, proceeding from room temperature, into an oven heated to 870°C, holding the temperature for 10 minutes, then allowing to cool to room temperature.

Both processes lead to homogeneous, very transparent layers which are free of microcracks. The layers adhere strongly on the surface of the wafer and cannot be removed with water.

The second sintering process comprises a significantly faster heating rate than the first. The coated wafer obtained by means of dispersion 6C exhibits a layer resistance of 20 to 30 ohms/sq, while values of more than 40 ohms/sq are achieved by the first sintering process. The wafers obtained by means of dispersions 2C and 3C have a layer resistance of more than 200 ohms/sq, which leads to the conclusion of insufficient doping with phosphorus.

Solid-state NMR spectroscopy: The wafers coated by means of dispersion 6C were analysed with ²⁹Si CPMAS NMR spectroscopy (CPMAS = charge-polarized magic angle spinning). The reference material used was a coated and sintered silicon wafer which had been produced by means of a dispersion which comprised hydrochloric acid instead of phosphoric acid.

The sample of the reference material exhibits the typical signal pattern of a pyrogenic silicon dioxide with Q2, Q3 and Q4 groups at -90, -98 and -111 ppm (Q2:Q3:Q4 = 25%:58%:18%). The spectrum of the sample resulting from dispersion 6C has changed significantly (Q2:Q3:Q4 = 10%:31%:59%). While the signal contribution at -90 and -98 ppm has decreased greatly, the signal at -111 increases. The centre of the signal is now at -115 ppm. The ³¹P MAS NMR spectrum (MAS = magic angle spinning) of the sample resulting from dispersion 6C exhibits an intense signal at -44 ppm and two weak signals at 1 and -11 ppm. The values suggest incorporation into the silicon matrix.
XPS/ESCA (XPS = X-ray photoelectron spectroscopy, ESCA = electron spectroscopy for chemical analysis): A binding energy value P₂ₚ of 135.6 eV was measured. This value is above the typical reference values for inorganic phosphates (AlPO₄ 132.9; P₂O₅ 135.2; NaPO₃ 134.7; Na₃PO₄ 132.4; Na₂HPO4 133.1; NaH₂PO₄ 134.2 eV). This leads to the conclusion of the presence of ...-Si-O-P-O-Si-... structures and/or structures of the Si-O-PO(OH)₂ type.

It is possible with the inventive dispersion to obtain thin and homogeneous layers on an EFG wafer and simultaneously to dope the wafer with phosphorus. In the sintering process, layer resistances of < 40 ohms/sq can be realized.

**Table 1: Start dispersions**

| **Example** | | **1A** | **2A** | **3A** | **4A** | **5A** | **6A** | **7A** | **8A** | **9A** | **10A** |
|---|---|---|---|---|---|---|---|---|---|---|---|
| Pyrogenic SiO₂ | g | 36.0 | 36.0 | 36.0 | 36.0 | 36.0 | 36.0 | 36.0 | 36.0 | 60.0 | 36.0 |
| Water | g | 264.0 | 264.0 | 264.0 | 264.0 | 264.0 | 264.0 | 264.0 | 264.0 | 240.0 | 264.0 |
| H₃PO₄ | g | 54.0 | 1.9 | 9.2 | 72.0 | 54.0 | 72.0 | 96.0 | 72.0 | 84.0 | 72.0 |
| Water ttl. | g | 272.1 | 264.3 | 265.4 | 274.8 | 272.1 | 274.8 | 278.4 | 274.8 | 252.6 | 274.8 |
| Sum | g | 354.0 | 301.9 | 309.2 | 372.0 | 354.0 | 372.0 | 396.0 | 372.0 | 384.0 | 372.0 |
| | | | | | | | | | | | |
| Water | % by wt. | 76.9 | 87.5 | 85.8 | 73.9 | 76.9 | 73.9 | 70.3 | 73.9 | 65.8 | 73.9 |
| Pyrogenic SiO₂ | % by wt. | 10.2 | 11.9 | 11.6 | 9.7 | 10.2 | 9.7 | 9.1 | 9.7 | 15.6 | 9.7 |
| H₃PO₄ | % by wt. | 12.97 | 0.53 | 2.53 | 16.45 | 12.97 | 16.45 | 20.61 | 16.45 | 18.59 | 16.45 |
| | | | | | | | | | | | |
| H₃PO₄/SiO₂ | mol/mol | 0.78 | 0.03 | 0.13 | 1.04 | 0.78 | 1.04 | 1.39 | 1.04 | 0.73 | 1.04 |

| | | | | | | | | | | | |
|---|---|---|---|---|---|---|---|---|---|---|---|
| * 85% by weight in water | | | | | | | | | | | |

**Table 2: Dispersions admixed with TEOS**

| **Example** | | **1B** | **2B** | **3B** | **4B** | **5B** | **6B** | **7B** | **8B** | **9B** | **10B** |
|---|---|---|---|---|---|---|---|---|---|---|---|
| Si(OEt)₄ addition | g | 0.0 | 100.0 | 100.0 | 100.0 | 100.0 | 100.0 | 100.0 | 50.0 | 50.0 | 140.0 |
| corresponds to SiO₂ | g | 0.0 | 28.8 | 28.8 | 28.8 | 28.8 | 28.8 | 28.8 | 14.4 | 34.6 | 40.3 |
| corresponds to ethanol | g | 0.0 | 88.5 | 88.5 | 88.5 | 88.5 | 88.5 | 88.5 | 88.5 | 106.1 | 123.8 |
| Water | g | 272.1 | 255.6 | 256.7 | 266.2 | 263.5 | 266.2 | 269.8 | 266.2 | 244.0 | 266.2 |
| SiO₂ ttl. | g | 36.0 | 64.8 | 64.8 | 64.8 | 64.8 | 64.8 | 64.8 | 50.4 | 94.6 | 76.3 |
| Sum | g | 354.0 | 410.5 | 417.8 | 480.6 | 462.6 | 480.6 | 504.6 | 466.2 | 516.1 | 527.5 |
| | | | | | | | | | | | |
| Water | % by wt. | 76.9 | 62.3 | 61.4 | 55.4 | 57.0 | 55.4 | 53.5 | 57.1 | 47.3 | 50.5 |
| Pyrogenic SiO₂ | % by wt. | 10.2 | 8.8 | 8.6 | 7.5 | 7.8 | 7.5 | 7.1 | 7.7 | 11.6 | 6.8 |
| SiO₂ from hydrolysis | % by wt. | 0.0 | 7.0 | 6.9 | 6.0 | 6.2 | 6.0 | 5.7 | 3.1 | 6.7 | 7.6 |
| ttl. SiO₂ | % by wt. | 10.2 | 15.8 | 15.5 | 13.5 | 14.0 | 13.5 | 12.8 | 10.8 | 18.3 | 14.5 |
| EtOH | % by wt. | 0.0 | 21.5 | 21.2 | 18.4 | 19.1 | 18.4 | 17.5 | 19.0 | 20.6 | 23.5 |
| H₃PO₄ | % by wt. | 13.0 | 0.39 | 1.87 | 12.73 | 9.92 | 12.73 | 16.17 | 13.13 | 13.84 | 11.60 |
| | | | | | | | | | | | |
| H₃PO₄/SiO₂ | mol/mol | 0.8 | 0.02 | 0.07 | 0.58 | 0.43 | 0.58 | 0.77 | 0.74 | 0.46 | 0.49 |
| SiO₂ hydrolysis*/SiO₂ pyrogenic | | 0.0 | 0.80 | 0.80 | 0.80 | 0.80 | 0.80 | 0.80 | 0.40 | 0.58 | 1.12 |

| | | | | | | | | | | | |
|---|---|---|---|---|---|---|---|---|---|---|---|
| *) calculated as SiO₂ | | | | | | | | | | | |

**Table 3: Diluted dispersions**

| **Example** | | **1C** | **2C** | **3C** | | **5C** | **6C** | **7C** | **8C** | **9C** | **10C** |
|---|---|---|---|---|---|---|---|---|---|---|---|
| Ethanol | g | 444.0 | 444.0 | 444.0 | - | 444.0 | 444.0 | 444.0 | 444.0 | 350.0 | 500.0 |
| Ethanol ttl. | g | 444.0 | 532.5 | 532.5 | - | 532.5 | 532.5 | 532.5 | 532.5 | 456.1 | 623.8 |
| Sum of dispersion | g | 798.0 | 854.5 | 861.8 | - | 906.6 | 924.6 | 948.6 | 910.2 | 866.1 | 1027.5 |
| | | | | | | | | | | | |
| Water | % by wt. | 34.1 | 29.9 | 29.8 | - | 29.1 | 28.8 | 28.4 | 29.2 | 28.2 | 25.9 |
| Pyrogenic SiO₂ | % by wt. | 4.5 | 4.2 | 4.2 | - | 4.0 | 3.9 | 3.8 | 4.0 | 6.9 | 3.5 |
| SiO₂ from hydrolysis | % by wt. | 0.0 | 3.4 | 3.3 | - | 3.2 | 3.1 | 3.0 | 1.6 | 4.0 | 3.9 |
| ttl. SiO₂ | % by wt. | 4.5 | 7.6 | 7.5 | - | 7.1 | 7.0 | 6.8 | 5.5 | 10.9 | 7.4 |
| EtOH | % by wt. | 55.6 | 62.3 | 61.8 | - | 58.7 | 57.6 | 56.1 | 58.5 | 52.7 | 60.7 |
| H₃PO₄ | % by wt. | 5.75 | 0.19 | 0.91 | - | 5.06 | 6.62 | 8.60 | 6.72 | 8.24 | 5.96 |
| | | | | | | | | | | | |
| EtOH/water | mol/mol | 0.64 | 0.81 | 0.81 | - | 0.79 | 0.78 | 0.77 | 0.78 | 0.73 | 0.92 |
| H₃PO₄/SiO₂ | mol/mol | 0.78 | 0.02 | 0.07 | - | 0.43 | 0.58 | 0.77 | 0.74 | 0.47 | 0.49 |
| SiO₂ hydrolysis*/SiO₂ pyrogenic | | 0.00 | 0.80 | 0.80 | - | 0.80 | 0.80 | 0.80 | 0.40 | 0.77 | 1.12 |

| | | | | | | | | | | | |
|---|---|---|---|---|---|---|---|---|---|---|---|
| *) calculated as SiO₂ | | | | | | | | | | | |

## Claims

1. Process for preparing a silicon dioxide dispersion comprising phosphoric acid, **characterized in that** phosphoric acid is added with stirring to a start dispersion I which comprises water and silicon dioxide particles to form start dispersion II, and then at least one silicon compound is added to start dispersion II and is hydrolysed in start dispersion II to form the silicon dioxide dispersion comprising phosphoric acid, where
- start dispersion I contains
- 80 to 95% by weight of water
- 5 to 20% by weight of silicon dioxide
- and the sum of water and silicon dioxide is at least 98% by weight, based on start dispersion I,
- start dispersion II contains
- 60 to 90% by weight of water
- 5 to 20% by weight of silicon dioxide
- 5 to 25% by weight of phosphoric acid, selected from ortho-phosphoric acid, diphosphoric acid and/or polyphosphoric acid, and
- the sum of water, silicon dioxide and phosphoric acid is at least 98% by weight, based on the start dispersion,
- the silicon dioxide particles of start dispersion I and of start dispersion II have
- a BET surface area of 80 to 350 m²/g,
- and a mean aggregate diameter of less than 200 nm,
- the silicon compound which is hydrolysed in start dispersion II
- is selected from at least one compound of the general formula (R₁O)ₓSi(OR₂)₄₋ₓ where R₁ and R₂ = Me, Et, n-propyl, isopropyl, n-butyl, x = 0-4 and R₁ ≠ R₂, and
- is added in an amount such that the ratio of silicon dioxide from hydrolysis (calculated)/ silicon dioxide from start dispersion II is 0.2 to 1.2.

2. Process according to Claim 1, **characterized in that** the silicon dioxide in start dispersion I and start dispersion II is a pyrogenic silicon dioxide.

3. Process according to Claim 1 or 2, **characterized in that** the BET surface area of the silicon dioxide is 150 to 250 m²/g.

4. Process according to Claims 1 to 3, **characterized in that** the mean aggregate diameter of the silicon dioxide particles in start dispersion I and start dispersion II is less than 100 nm.

5. Process according to Claims 1 to 4, **characterized in that** the content of silicon dioxide in start dispersion I is 10 to 15% by weight.

6. Process according to Claims 1 to 5, **characterized in that** the ratio of silicon dioxide from hydrolysis (calculated)/silicon dioxide from start dispersion II is 0.4 to 0.8.

7. Process according to Claims 1 to 6, **characterized in that** the silicon compound which is hydrolysed is tetramethoxysilane and/or tetraethoxysilane.

8. Process according to Claims 1 to 7, **characterized in that** the silicon dioxide dispersion comprising phosphoric acid is diluted with at least one volatile organic solvent which is soluble in the liquid phase of the dispersion, wherein soluble is understood to mean that, after addition of the solvent, no immiscible liquid phase is formed and volatile is understood to mean that the organic solvents can be removed again at temperatures up to 300°C.

9. Process according to Claim 8, **characterized in that** the soluble volatile organic solvent is an alcohol selected from methanol, ethanol, n-propanol, isopropanol, n-butanol and/or 1,2-ethanediol.

10. Process according to Claim 8 or 9, **characterized in that** the weight ratio of soluble volatile organic solvent/water is 0.2 to 4.

11. Silicon dioxide dispersion comprising phosphoric acid, **characterized in that** it contains
- 3 to 7.5% by weight of pyrogenic silicon dioxide particles having a BET surface area of 150 to 250 m²/g, a mean aggregate diameter of the silicon dioxide particles of less than 100 nm,
- 1.5 to 5% by weight of hydrolysis and condensation products of tetraethoxysilane, which have formed in the dispersion in the presence of the pyrogenic silicon dioxide particles,
- 5 to 9% by weight of phosphoric acid, calculated as H3PO4,
- 25 to 30% by weight of water,
- 50 to 65% by weight of ethanol,
- where the proportion of these substances is at least 98% by weight, based on the total amount of the dispersion.

12. Process for coating a silicon wafer, **characterized in that** the phosphorus-containing silicon dioxide dispersion according to Claim 11 is applied to a silicon wafer then the coated silicon wafer is dried and sintered, wherein the sintering step of the process according to is performed by introducing the coated and dried silicon wafer, which is at room temperature, into an environment which has a temperature of 850 to 930°C, keeping the silicon wafer at this temperature for 5 to 15 minutes and then transferring it into an environment at room temperature and allowing it to cool there.

## Patentansprüche

1. Verfahren zum Herstellen einer Siliciumdioxiddispersion, umfassend Phosphorsäure, **dadurch gekennzeichnet, dass**
Phosphorsäure unter Rühren zu einer Ausgangsdispersion I zugegeben wird, die Wasser und Siliciumdioxidteilchen umfasst, um die Ausgangsdispersion II zu bilden, und anschließend wenigstens eine Siliciumverbindung zu der Ausgangsdispersion II zugegeben und in der Ausgangsdispersion II hydrolysiert wird, um die Siliciumdioxiddispersion, umfassend Phosphorsäure, zu bilden, wobei
- die Ausgangsdispersion I enthält:
- 80 bis 95 Gew.-% Wasser,
- 5 bis 20 Gew.-% Siliciumdioxid,
- wobei die Summe von Wasser und Siliciumdioxid wenigstens 98 Gew.-% beträgt, bezogen auf die Ausgangsdispersion I,
- die Ausgangsdispersion II enthält:
- 60 bis 90 Gew.-% Wasser,
- 5 bis 20 Gew.-% Siliciumdioxid,
- 5 bis 25 Gew.-% Phosphorsäure, ausgewählt aus ortho-Phosphorsäure, Diphosphorsäure und/oder Polyphosphorsäure,
- wobei die Summe von Wasser, Siliciumdioxid und Phosphorsäure wenigstens 98 Gew.-% beträgt, bezogen auf die Ausgangsdispersion,
- die Siliciumdioxidteilchen der Ausgangsdispersion I und der Ausgangsdispersion II
- eine BET-Oberfläche von 80 bis 350 m²/g und
- einen mittleren Aggregatdurchmesser von weniger als 200 nm
aufweisen,
- die Siliciumverbindung, die in der Ausgangsdispersion II hydrolysiert wird,
- ausgewählt ist aus wenigstens einer Verbindung der allgemeinen Formel (R₁O)ₓSi(OR₂)₄₋ₓ, wobei R₁ und R₂ = Me, Et, n-Propyl, Isopropyl, n-Butyl, x = 0-4 und R₁ ≠ R₂, und
- in einer Menge zugegeben wird, bei der das Verhältnis von Siliciumdioxid aus der Hydrolyse (berechnet)/Siliciumdioxid aus der Ausgangsdispersion II 0,2 bis 1,2 beträgt.

2. Verfahren gemäß Anspruch 1, **dadurch gekennzeichnet, dass** das Siliciumdioxid in der Ausgangsdispersion I und der Ausgangsdispersion II ein pyrogenes Siliciumdioxid ist.

3. Verfahren gemäß Anspruch 1 oder 2, **dadurch gekennzeichnet, dass** die BET-Oberfläche des Siliciumdioxids 150 bis 250 m²/g beträgt.

4. Verfahren gemäß Ansprüchen 1 bis 3, **dadurch gekennzeichnet, dass** der mittlere Aggregatdurchmesser der Siliciumsdioxidteilchen der Ausgangsdispersion I und der Ausgangsdispersion II weniger als 100 nm beträgt.

5. Verfahren gemäß Ansprüchen 1 bis 4, **dadurch gekennzeichnet, dass** der Gehalt an Siliciumdioxid in der Ausgangsdispersion I 10 bis 15 Gew.-% beträgt.

6. Verfahren gemäß Ansprüchen 1 bis 5, **dadurch gekennzeichnet, dass** das Verhältnis von Siliciumdioxid aus der Hydrolyse (berechnet)/Siliciumdioxid aus der Ausgangsdispersion II 0,4 bis 0,8 beträgt.

7. Verfahren gemäß Ansprüchen 1 bis 6, **dadurch gekennzeichnet, dass** die Siliciumverbindung, die hydrolysiert wird, Tetramethoxysilan und/oder Tetraethoxysilan ist.

8. Verfahren gemäß Ansprüchen 1 bis 7, **dadurch gekennzeichnet, dass** die Siliciumdioxiddispersion, umfassend Phosphorsäure, mit wenigstens einem flüchtigen organischen Lösungsmittel, das in der flüssigen Phase der Dispersion löslich ist, verdünnt wird, wobei löslich bedeuten soll, dass nach Zugeben des Lösungsmittels keine nicht mischbare flüssige Phase entsteht, und flüchtig bedeuten soll, dass die organischen Lösungsmittel bei Temperaturen bis 300 °C wieder entfernt werden können.

9. Verfahren gemäß Anspruch 8, **dadurch gekennzeichnet, dass** das lösliche, flüchtige organische Lösungsmittel ein Alkohol ist, ausgewählt aus Methanol, Ethanol, n-Propanol, Isopropanol, n-Butanol und/oder 1,2-Ethandiol.

10. Verfahren gemäß Anspruch 8 oder 9, **dadurch gekennzeichnet, dass** das Gewichtsverhältnis von löslichem, flüchtigem organischem Lösungsmittel/Wasser 0,2 bis 4 beträgt.

11. Siliciumdioxiddispersion, umfassend Phosphorsäure, **dadurch gekennzeichnet, dass** sie enthält:
- 3 bis 7,5 Gew.-% pyrogene Siliciumdioxidteilchen mit einer BET-Oberfläche von 150 bis 250 m²/g, einem mittleren Aggregatdurchmesser der Siliciumdioxidteilchen von weniger als 100 nm,
- 1,5 bis 5 Gew.-% Hydrolyse- und Kondensationsprodukte von Tetraethoxysilan, die in der Dispersion in Gegenwart der pyrogenen Siliciumdioxidteilchen entstanden sind,
- 5 bis 9 Gew.-% Phosphorsäure, berechnet als H₃PO₄,
- 25 bis 30 Gew.-% Wasser,
- 50 bis 65 Gew.-% Ethanol,
- wobei der Anteil dieser Stoffe, bezogen auf die Gesamtmenge der Dispersion, wenigstens 98 Gew.-% beträgt.

12. Verfahren zum Beschichten einer Siliciumscheibe, **dadurch gekennzeichnet, dass** die Phosphorenthaltende Siliciumdioxiddispersion gemäß Anspruch 11 auf eine Siliciumscheibe aufgetragen wird, anschließend die beschichtete Siliciumscheibe getrocknet und gesintert wird, wobei der Sinterschritt des Verfahrens gemäß durch Einführen der beschichteten und getrockneten Siliciumscheibe, die sich bei Raumtemperatur befindet, in eine Umgebung, die eine Temperatur von 850 bis 930 °C aufweist, 5 bis 15 Minuten Halten der Siliciumscheibe bei dieser Temperatur und anschließend Überführen in eine Umgebung bei Raumtemperatur und dort abkühlen lassen durchgeführt wird.

## Revendications

1. Procédé pour la préparation d'une dispersion de dioxyde de silicium comprenant de l'acide phosphorique, **caractérisé en ce que** de l'acide phosphorique est ajouté sous agitation à une dispersion de départ I qui comprend de l'eau et des particules de dioxyde de silicium pour former une dispersion de départ II, puis au moins un composé du silicium est ajouté à la dispersion de départ II et est hydrolysé dans la dispersion de départ II pour former la dispersion de dioxyde de silicium comprenant de l'acide phosphorique, dans lequel
- la dispersion de départ I contient
- 80 à 95 % en poids d'eau
- 5 à 20 % en poids de dioxyde de silicium
- et la somme de l'eau et du dioxyde de silicium est d'au moins 98 % en poids, sur la base de la dispersion de départ I,
- la dispersion de départ II contient
- 60 à 90 % en poids d'eau
- 5 à 20 % en poids de dioxyde de silicium
- 5 à 25 % en poids d'acide phosphorique, choisi parmi l'acide orthophosphorique, l'acide diphosphorique et/ou l'acide polyphosphorique et
- la somme de l'eau, du dioxyde de silicium et de l'acide phosphorique est d'au moins 98 % en poids, sur la base de la dispersion de départ,
- les particules de dioxyde de silicium de la dispersion de départ I et de la dispersion de départ II ont
- une surface spécifique BET de 80 à 350 m²/g
- et un diamètre moyen des agrégats inférieur à 200 nm,
- le composé du silicium qui est hydrolysé dans la dispersion de départ II
- est choisi parmi au moins un composé représenté par la formule générale (R₁O)ₓSi(OR₂)₄₋ₓ dans laquelle R₁ et R₂ = Me, Et, n-propyle, isopropyle, *n*-butyle, x = 0-4 et R₁ ≠ R₂ et
- est ajouté en une quantité telle que le rapport dioxyde de silicium provenant de l'hydrolyse (calculé)/dioxyde de silicium provenant de la dispersion de départ II est de 0,2 à 1,2.

2. Procédé selon la revendication 1, **caractérisé en ce que** le dioxyde de silicium dans la dispersion de départ I et la dispersion de départ II est un dioxyde de silicium pyrogène.

3. Procédé selon la revendication 1 ou 2, **caractérisé en ce que** la surface spécifique BET du dioxyde de silicium est de 150 à 250 m²/g.

4. Procédé selon les revendications 1 à 3, **caractérisé en ce que** le diamètre moyen des agrégats des particules de dioxyde de silicium dans la dispersion de départ I et la dispersion de départ II est inférieur à 100 nm.

5. Procédé selon les revendications 1 à 4, **caractérisé en ce que** la teneur en dioxyde de silicium dans la dispersion de départ I est de 10 à 15 % en poids.

6. Procédé selon les revendications 1 à 5, **caractérisé en ce que** le rapport dioxyde de silicium provenant de l'hydrolyse (calculé)/dioxyde de silicium provenant de la dispersion de départ II est de 0,4 à 0,8.

7. Procédé selon les revendications 1 à 6, **caractérisé en ce que** le composé du silicium qui est hydrolysé est le tétraméthoxysilane et/ou le tétraéthoxysilane.

8. Procédé selon les revendications 1 à 7, **caractérisé en ce que** la dispersion de dioxyde de silicium comprenant de l'acide phosphorique est diluée avec au moins un solvant organique volatil qui est soluble dans la phase liquide de la dispersion, dans lequel soluble est entendu comme signifiant que, après ajout du solvant, il ne se forme pas de phase liquide non miscible et volatil est entendu comme signifiant que les solvants organiques peuvent être à nouveau enlevés à des températures allant jusqu'à 300 °C.

9. Procédé selon la revendication 8, **caractérisé en ce que** le solvant organique volatil soluble est un alcool choisi parmi le méthanol, l'éthanol, le n-propanol, l'isopropanol, le *n*-butanol et/ou le 1,2-éthanediol.

10. Procédé selon la revendication 8 ou 9, **caractérisé en ce que** le rapport pondéral solvant organique volatil soluble/eau est de 0,2 à 4.

11. Dispersion de dioxyde de silicium comprenant de l'acide phosphorique, **caractérisée en ce qu'**elle contient
- 3 à 7,5 % en poids de particules de dioxyde de silicium pyrogène ayant une surface spécifique BET de 150 à 250 m²/g, un diamètre moyen des agrégats des particules de dioxyde de silicium inférieur à 100 nm,
- 1,5 à 5 % en poids de produits d'hydrolyse et de condensation de tétraéthoxysilane, qui se sont formés dans la dispersion en présence des particules de dioxyde de silicium pyrogène,
- 5 à 9 % en poids d'acide phosphorique, calculé en termes de H₃PO₄,
- 25 à 30 % en poids d'eau,
- 50 à 65 % en poids d'éthanol,
- dans laquelle la proportion de ces substances est d'au moins 98 % en poids, sur la base de la quantité totale de la dispersion.

12. Procédé pour le revêtement d'une tranche de silicium, **caractérisé en ce que** la dispersion de dioxyde de silicium contenant du phosphore selon la revendication 11 est appliquée sur une tranche de silicium, puis la tranche de silicium revêtue est séchée et fritée, dans lequel on effectue l'étape de frittage du procédé en introduisant la tranche de silicium revêtue et séchée, qui est à température ambiante, dans un environnement qui a une température de 850 à 930 °C, en maintenant la tranche de silicium à cette température pendant 5 à 15 minutes puis en la transférant dans un environnement à température ambiante et en la laissant refroidir là.
